# FASCICULE DE BREVET EUROPEEN

(11) **EP 2 181 824 B1**
(45) Date de publication et mention de la délivrance du brevet: **13.07.2011**
(21) Numéro de dépôt: 09354046.6
(22) Date de dépôt: 02.11.2009
(51) Int. Cl.: B29C 33/38, G03F 7/00, C23C 28/00, C04B 41/53, B82B 3/00

(54) **Procédé de fabrication d'un moule pour pièces en matériau polymère nanostructurées**
Method for manufacturing a mould for parts made from nanostructured polymer material
Herstellungsverfahren eines Werkzeugs für Werkstücke aus nanostrukturierten Polymermaterialien

(30) Priorité: 04.11.2008 FR 0806143
(43) Date de publication de la demande: 05.05.2010
(73) Titulaire: Commissariat à l'Énergie Atomique et aux Énergies Alternatives, 75015 Paris (FR)
(72) Inventeur: Gavillet, Jérôme, 38120 Saint-Egrève (FR); Juliet, Pierre, 38100 Grenoble (FR)
(74) Mandataire: Dubreu, Sandrine

(56) Documents cités:
- EP-A- 1 884 505
- DE-A1-102008 009 035
- US-A1- 2005 084 804
- US-A1- 2005 138 803
- US-A1- 2005 170 292

## Description

### Domaine technique de l'invention

L'invention concerne un procédé de fabrication d'un moule pour pièces en matériau polymère.

### État de la technique

Les matériaux polymères sont largement utilisés pour réaliser des biens de consommation courante. De tels matériaux permettent en effet de produire en très grandes quantités et à faible coût de nombreux produits, par exemple dans le domaine du conditionnement, ou des composants dans le domaine de l'automobile, de la téléphonie mobile, des instruments médicaux, des énergies renouvelables... En général, les pièces sont réalisées par des procédés de fabrication classiques dans le domaine de la plasturgie. En particulier, elles peuvent être réalisées par moulage, soit à l'aide d'un procédé d'injection plastique, soit à l'aide d'un procédé d'emboutissage. Le procédé d'injection plastique implique une fusion du matériau polymère dans un moule tandis que l'emboutissage correspond à un thermoformage du matériau polymère, réalisé à l'aide d'un moule (également appelé matrice) à une température inférieure à la température de fusion du matériau polymère.

Les matériaux polymères sont également employés depuis quelques années dans des marchés de niche, pour lesquels les quantités produites sont moindres mais les exigences en termes de procédé de fabrication, de qualité et de fonctionnalité sont plus élevées. C'est, par exemple, le cas dans le domaine de la réalisation de dispositifs microfluidiques, de bio-puces, d'hologrammes,... De tels domaines nécessitent la réalisation de pièces miniaturisées d'une très grande précision quant à leur forme et à leur dimension. En particulier, la surface de ces pièces est en général structurée, c'est-à-dire qu'elle comporte un motif défini par des zones en relief et des zones en creux et les dimensions de ces zones (largeur, hauteur, pas) sont d'ordre micrométrique et, de plus en plus, d'ordre nanométrique. Dans ce dernier cas, on parle de surface dite nanostructurée, plus connue sous le terme anglo-saxon « nanopatterned surface ».

Par ailleurs, ces pièces miniaturisées, à forte valeur ajoutée, commencent à être employées dans les marchés plus traditionnels des biens de consommation courante, qui nécessitent la production de gros volumes et des coûts de fabrication faibles.

Ainsi, pour ce type de marchés, l'enjeu actuel est de pouvoir utiliser les procédés de fabrication classiques dans le domaine de la plasturgie (moulage par injection ou par emboutissage), qui sont des procédés facilement industrialisables et rentables, tout en maîtrisant la complexité, les dimensions et l'état de surface des pièces réalisées. En particulier, l'enjeu consiste à obtenir des pièces polymères présentant des surfaces nanostructurées correspondant parfaitement à la partie complémentaire de la surface du moule utilisé dans ces procédés de fabrication.

À titre d'exemple, les disques d'enregistrement optique de données, tels que les CD-Rom, sont réalisés en formant une piste présentant un motif ayant une taille inférieure au micromètre dans un substrat polymère par exemple en polycarbonate. Or, de tels disques sont, généralement, fabriqués en grande quantité, par un procédé de moulage par injection, à l'aide d'un moule ou d'un support matrice, également connu sous le nom anglo-saxon de « master disk » ou de « stamper ». Une des faces libres du support matrice est structurée sous une forme complémentaire au motif prédéterminé désiré pour les disques. En général, le support matrice métallique, destiné à servir de moule lors de la fabrication par moulage par injection des disques optiques, est, en général, obtenu à partir d'un modèle original préalablement structuré.

La durabilité, l'entretien, la maintenance et le vieillissement des moules utilisés et plus particulièrement de leurs surfaces sont des facteurs clefs pour assurer une qualité pérenne des objets produits. Or, l'ensemble de ces contraintes est encore plus limitant lors d'un passage d'une échelle macro- ou microscopique vers une échelle nanoscopique. La phase de démoulage est également une des étapes cruciales du procédé de fabrication, car cette phase joue un rôle important pour la productivité des pièces polymères réalisées. En effet, cette phase peut générer un grand nombre de rebuts s'il existe une mauvaise reproductibilité de la surface du moule ou bien des rayures à la surface dudit moule ... Elle peut aussi perturber le procédé de fabrication, par exemple en cas d'encrassement dû à un éventuel collage du polymère dans le moule.

Actuellement, la formation d'une surface nanostructurée pour des moules métalliques peut être réalisée en formant une nanostructure par lithographie par faisceau d'électrons, puis en rapportant cette nanostructure à la surface d'un film métallique. La nanostructure créée par lithographie par faisceau d'électrons peut également servir de masque dur pour graver un motif nanostructuré dans un substrat qui formera le moule. Cependant, la technique de lithographie par faisceau d'électrons est longue et très coûteuse. De plus, elle n'est adaptée qu'à des applications particulières pour lesquelles l'organisation des motifs prévaut, en particulier dans le domaine optique et électronique. Des approches alternatives sont actuellement considérées pour nanostructurer un moule à plus faible coût. Par exemple, il a déjà été proposé de micro- ou nanostructurer des feuilles d'aluminium par anodisation, afin de les utiliser comme moules pour réaliser des pièces en polyoléfine.

La demande de brevet US2005/0084804 décrit l'emploi d'une couche anti-adhérente en carbone quasi-diamant pour réaliser un moule destiné à recevoir un matériau polymère réticulé. La couche en carbone quasi-diamant, également appelée DLC (« diamond-like carbon »), est déposée sur un support principal et elle est structurée par gravure sèche réactive sous oxygène, afin de réaliser une surface structurée. Dans un mode particulier de réalisation, une couche en matériau conducteur électriquement, par exemple en oxyde d'indium et d'étain (ITO), peut être déposée entre le support principal et la couche en DLC.

### Objet de l'invention

L'invention a pour but de proposer un procédé de fabrication, facile à mettre en oeuvre et à faible coût, d'un moule ayant une durée de vie améliorée et permettant de réaliser, de manière fiable et précise, des pièces en matériau polymère nanostructurées.

Selon l'invention, ce but est atteint par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, schématiquement et en coupe un mode particulier de réalisation d'un moule selon l'invention.
- les figures 2 à 9 représentent, schématiquement et en coupe, différentes étapes d'un procédé particulier de réalisation du moule selon la figure 1.
- les figures 10 à 12 sont des clichés obtenus par microscopie électronique à balayage de différents assemblages de nanoparticules pouvant être déposées à la surface du masque dur, lors du procédé particulier de réalisation d'un moule.

### Description de modes particuliers de réalisation

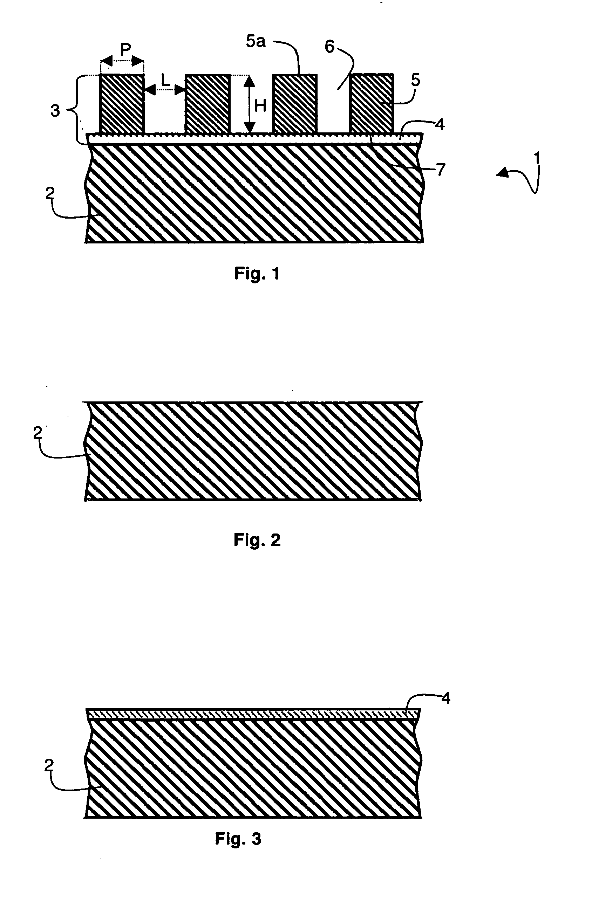

La figure 1 illustre un mode particulier de réalisation d'un moule 1, adapté pour réaliser par moulage (par exemple par injection plastique ou par emboutissage) des pièces en matériau polymère présentant une surface nanostructurée.

Le moule 1 comporte un support métallique 2 qui constitue la partie principale du moule et assure, en particulier, la tenue mécanique du moule 1. Le support métallique est, par exemple, formé par un matériau ou un alliage métallique, tel que l'aluminium, l'acier ou le laiton...

De plus, un revêtement 3 constitué de deux couches minces superposées recouvre au moins en partie une surface du support métallique 2. Un tel revêtement permet de munir le moule 1 d'une surface nanostructurée, destinée à être mise en contact avec un matériau polymère lors de la fabrication de pièces en matériau polymère.

Le revêtement 3, également appelé revêtement bicouche, est ainsi formé d'une couche mince barrière 4 en contact avec le support métallique 2 et sur laquelle est disposée une couche mince nanostructurée 5, en carbone quasi-diamant, également appelé DLC (« diamond-like carbon ») ou carbone diamant amorphe. Le revêtement a, de plus, une épaisseur comprise entre environ 100 nm et environ 10 µm.

La couche mince barrière 4 permet, en particulier, de réaliser la nanostructuration de la couche mince en carbone quasi-diamant lors du procédé d'élaboration du moule 1 sans endommager le support métallique 2. Elle peut, par exemple, être en carbure de silicium hydrogéné. Ce matériau permet aussi d'assurer une adhésion optimum entre la couche en carbone quasi-diamant et le matériau inorganique du moule 1. Dans ce cas, la couche mince barrière 4 a avantageusement une épaisseur comprise entre 50nm et 500nm.

La couche mince barrière 4 peut être aussi être en nitrure de chrome. Dans ce cas, elle a avantageusement une épaisseur comprise entre environ 50 nm et environ 500nm. La couche mince 4 en nitrure de chrome joue alors non seulement le rôle de barrière physique lors de la nanostructuration de la couche mince 5 en DLC, mais le nitrure de chrome étant un matériau à faible coefficient de frottement, la couche mince barrière 4 permet également d'améliorer l'aptitude au démoulage du moule.

Ainsi, la couche mince en DLC 5 est, plus particulièrement, nanostructurée selon un motif prédéterminé formant la surface nanostructurée du moule 1. Un tel motif correspond, plus particulièrement, à la partie complémentaire du motif souhaité pour les pièces en matériau polymère réalisées à l'aide du moule 1. Par conséquent, la forme du motif est déterminée par celle souhaitée pour le motif des pièces en matériau polymère. En particulier, sur la figure 1, le motif est constitué d'une pluralité d'ouvertures 6 formées dans la couche mince en DLC 5 et traversant ladite couche mince 5 depuis sa surface libre 5a jusqu'à l'interface 7 entre la couche mince 5 et la couche mince barrière 4.

Par ailleurs, le motif présente des dimensions nanométriques, c'est-à-dire des zones en creux par rapport au reste de la couche mince en DLC 5 dont la hauteur et la largeur sont de dimensions nanométriques et donc avantageusement comprises entre environ 5 nm et environ 500 nm. En particulier, le rapport de forme, c'est-à-dire le rapport moyen entre la hauteur des zones en creux dudit motif et la largeur des zones en creux, est au moins supérieur à 1. Ainsi, le motif présente des zones en creux ayant une hauteur (ou profondeur) supérieure à leur largeur. Un tel rapport de forme élevé, supérieur à 1, est, en particulier, requis pour des pièces en matériau polymère présentant une surface autonettoyante, par exemple dans le domaine des nouvelles générations de téléphones portables.

Ainsi, sur la figure 1, pour chaque ouverture 6, le rapport entre la hauteur H de l'ouverture 6 et la largeur L de l'ouverture 6 est supérieur à 1. H correspond aussi, sur la figure 1, à l'épaisseur de la couche mince en DLC 5. À titre d'exemple, chaque ouverture 6 peut avoir une hauteur H égale à 50 nm et une largeur L égale à 20 nm et elle peut être séparée d'une ouverture adjacente par un pas de 50 nm.

Un tel moule 1 présente l'avantage d'intégrer une surface nanostructurée destinée à être transférée négativement par moulage aux pièces en matériau polymère réalisées. Ainsi, le fait de nanostructurer l'outil plutôt que les pièces en matériau polymère permet de réaliser les pièces de manière fiable et précise.

De plus, la nanostructuration n'est pas ici directement réalisée dans le support métallique, qui forme en général dans l'état de la technique, le moule 1. Elle est au contraire réalisée dans un revêtement de dimensions micrométriques recouvrant le support métallique. La nanostructuration est, plus particulièrement, réalisée dans une couche mince en carbone quasi-diamant tandis qu'une couche mince barrière est disposée entre ladite couche mince en carbone quasi-diamant et le support métallique pour protéger le support métallique lors de la réalisation de la nanostructuration. Ceci contribue également à améliorer la fiabilité et la précision des pièces en matériau polymère réalisée.

De plus, la couche mine nanostructurée rapportée sur le support métallique correspond à une couche sacrificielle fonctionnelle et recyclable. Les contraintes de cycles et de durée de vie du moule sont ainsi transférées du support métallique vers cette couche sacrificielle qui est moins chère à fabriquer que le support métallique si celui-ci était nanostructuré.

Enfin, le choix du carbone quasi-diamant (DLC) pour réaliser la couche mince nanostructurée 5 est particulièrement avantageux dans la mesure où le DLC est non seulement un matériau à faible coefficient de frottement, ce qui facilite l'étape de démoulage lors de la réalisation des pièces en matériau polymère, tout en pouvant être nanostructuré facilement et de manière économique. De plus, les motifs réalisés dans une couche en DLC peuvent avoir diverses formes possibles. Ainsi, un tel moule permet d'obtenir le meilleur compromis possible entre la faisabilité technique pour réaliser des pièces en matériau polymère nanostructurées et la faisabilité économique.

En particulier, les figures 2 à 9 illustrent les différentes étapes de réalisation d'un moule 1 selon la figure 1 et plus particulièrement la nanostructuration de la couche mince en DLC.

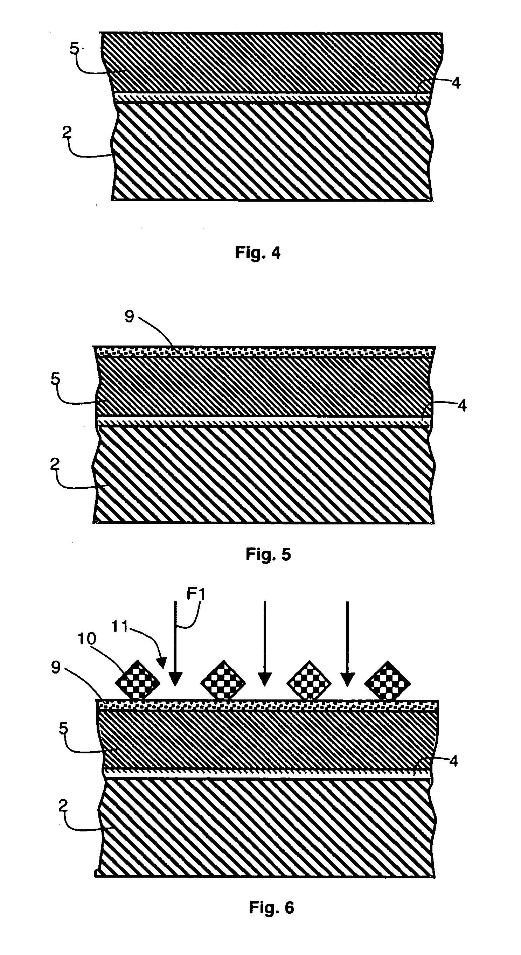

La couche mince barrière 4 est ainsi préalablement déposée sur le support métallique 2. Puis, comme représenté sur la figure 4, une couche mince en DLC 5 est déposée sur la surface libre de la couche mince barrière 4. À ce stade du procédé, la couche mince en DLC 5 n'est pas encore nanostructurée. Ainsi, sur la figure 4, elle est sous la forme d'une couche mince d'une épaisseur constante, recouvrant la totalité de la surface libre de la couche mince barrière 4.

Les couches minces 4 et 5 peuvent, par exemple, être déposées par dépôt physique en phase vapeur (PVD) ou bien par dépôt chimique en phase vapeur (CVD) à l'aide d'au moins un précurseur organo-métallique.

A titre d'exemple, les couches 4 et 5 peuvent être déposées par un procédé CVD assisté par un plasma basse fréquence (40 kHz). Une couche 4, en carbure de silicium amorphe, est réalisée à partir d'un mélange de C₄H₁₂Si et d'argon (50%-50%) avec un espace inter-électrode de 200 mm, une densité de puissance plasma de 0,10 W/cm², une pression de gaz de 4 Pa et une température inférieure à 150°C. La couche 5, en DLC, est réalisée à partir d'un mélange de C₄H₁₂ et d'hydrogène (80%-20%), un espace inter-électrode de 200 mm, une densité de puissance plasma de 0,32 W/cm², une pression de gaz de 4 Pa et une température inférieure à 150 °C. Par ailleurs, l'épaisseur des couches 4 et 5 est déterminée par la durée du dépôt de chaque couche.

Ensuite, comme représenté aux figures 5 à 9, la couche mince en DLC 5 est nanostructurée à l'aide d'un masque dur nanostructuré 8, formé sur la surface libre de la couche mince en DLC 5.

Plus particulièrement, le masque dur 8 est réalisé en déposant un film mince 9 sur la totalité de la surface libre de ladite couche mince en DLC 5 (figure 5). Le film mince 9 présente une épaisseur constante qui est, de préférence comprise entre 10nm et 50nm. Par ailleurs, le film mince 9 est constitué d'un matériau apte à former un masque dur adapté à la nanostructuration de la couche mince en DLC 5. Avantageusement, un tel matériau est choisi parmi l'oxyde de silicium, le carbure de silicium hydrogéné, le nitrure de silicium, un matériau métallique tel que l'aluminium, le cuivre, le chrome, et un nitrure métallique tel que le nitrure de chrome... Le film mince 9 est, par exemple, déposé par PVD ou par CVD.

Un tel masque dur 8 présente l'avantage d'être une couche sacrificielle, pouvant être retirée chimiquement une fois la couche mince en DLC 5 nanostructurée. De plus, avantageusement, le même matériau que celui utilisé pour réaliser la couche mince barrière 4 peut être utilisé pour réaliser le masque dur 8. Ceci permet alors de simplifier l'étape d'élimination du masque dur 8. En exemple, lorsque la couche mince barrière 4 est en carbure de silicium hydrogéné, ce matériau peut également être utilisé pour réaliser le film mince 9 et donc le masque dur 8.

Des nanoparticules 10, c'est-à-dire des particules de dimensions nanométriques, sont ensuite déposées sur la surface libre dudit film mince 9 (figure 6) de telle manière qu'elles délimitent un réseau d'interstices 11. Le réseau d'interstices 11 peut être organisé ou non. Les nanoparticules ont, en particulier, une taille moyenne inférieure à 200 nm. Elles peuvent être déposées par tout type de méthodes adaptées selon le type de motif souhaité (forme, dimensions,...) pour le masque dur 8 et donc pour le type de motif souhaité pour la couche mince en DLC 5. À titre d'exemple, les nanoparticules peuvent être déposées par :
- une technique de pulvérisation magnétron associée à une condensation de la vapeur sous formes d'agrégats dans un étage à haute pression et à un tri en masse de ces agrégats avant dépôt sur la surface libre du film mince 9. A titre d'exemple, la société MANTIS commercialise ce type d'équipement sous l'appellation « *Nanocluster Deposition »*
- un procédé CVD assisté par injection liquide (Un tel procédé est par exemple décrit dans la demande internationale WO-A-2006/070130).
- une technique de dépôt du type Langmuir-Blodgett permettant le transfert d'une monocouche de nanoparticules d'un bain liquide vers la surface libre du film mince 9, par immersion puis retrait contrôlé de celui-ci. La société NANOMETRIX commercialise ce type d'équipement sous l'appellation « Driven Monolayer Assembly Process» ou procédé « DMA ».

Le choix de la méthode utilisée dépend, plus particulièrement, du type de motif souhaité pour le masque dur. En effet, la méthode employée détermine le type de matériaux constituant les nanoparticules 10, leur taille moyenne et le type de réseau d'interstices formé.

Ainsi, la technique de dépôt par pulvérisation magnétron permet de déposer nanoparticules d'un métal choisi parmi l'argent, l'or, le palladium, le platine, le cuivre, le titane, le zirconium,...ou d'un alliage ou d'un composé métallique tel que l'oxyde de titane ou l'oxyde de zirconium, ou de silicium ou d'e l'un de ses composés tels que le carbure de silicium, l'oxyde de silicium et le nitrure de silicium. Les nanoparticules 10 ont, en particulier, une taille moyenne comprise entre environ 1 nm et environ 10 nm avec un réseau d'interstices 10 présentant un faible taux d'organisation.

La technique de dépôt CVD assisté par injection liquide permet quant à elle de déposer des nanoparticules d'oxyde de fer ou d'un métal tel que l'argent, le platine et le cuivre.... Les nanoparticules ont une taille moyenne comprise entre environ 1nm et environ 50 nm avec un réseau d'interstices 10 présentant un faible taux d'organisation.

Enfin, avec le procédé Langmuir-Blodgett, les nanoparticules 10 déposées peuvent être des nanoparticules d'un matériau choisi parmi le carbure de silicium, l'oxyde de silicium, le nitrure de silicium, un matériau polymère, l'oxyde de titane et l'oxyde de zirconium en oxyde de silicium ou en polymère et elles ont une taille moyenne inférieure à 500 nm et elles sont par ailleurs déposées avec un taux d'organisation très élevé.

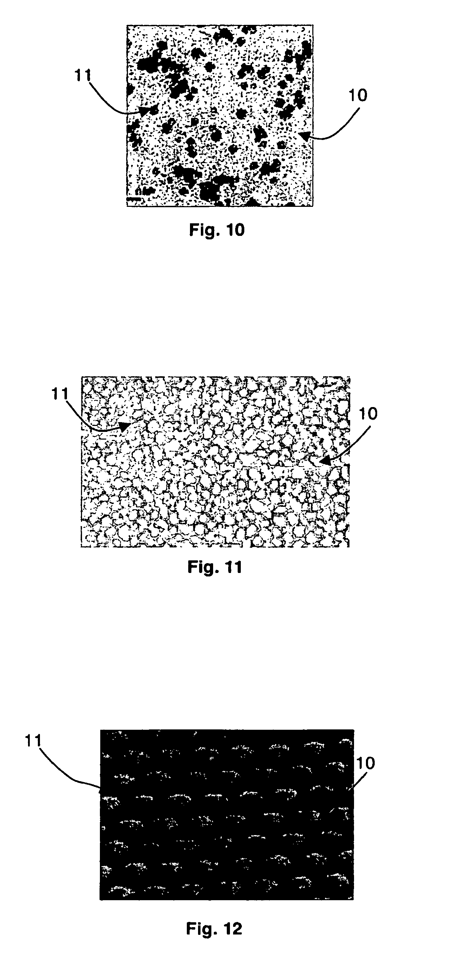

À titre d'exemple, les figures 10 à 12 représentent respectivement des clichés obtenus par microscopie électronique à balayage de nanoparticules déposées selon les trois méthodes de dépôt mentionnées ci-dessus. Ainsi, les nanoparticules 10 sur la figure 10 sont des nanoparticules en alliage d'or et palladium déposées par pulvérisation magnétron et d'une taille moyenne de 1, de 3 ou de 5 nm. Sur la figure 11, des nanoparticules 10 en argent ont été déposées par un procédé CVD par injection liquide. Elles ont une taille moyenne de 50 nm. Enfin, les nanoparticules 10 de la figure 12 déposées par le procédé Langmuir-Blodgett sont en oxyde de silicium et elles ont une taille moyenne de 50 nm. Sur chacun des clichés 10 à 12, on constate la présence d'un réseau d'interstices 11 délimité par les nanoparticules 10 et à travers lequel pourra être réalisée l'ouverture du masque dur 8.

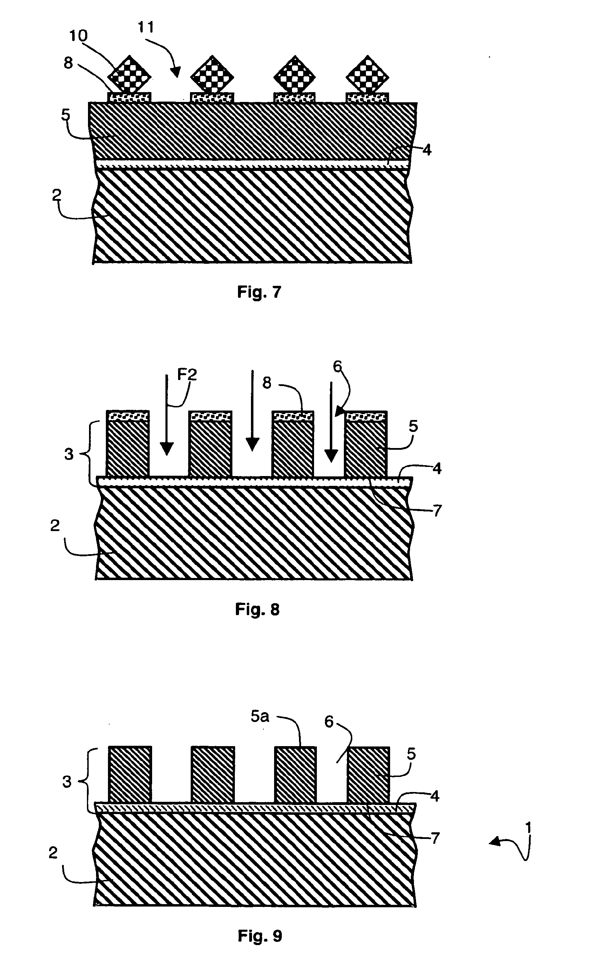

Une fois les nanoparticules 10 déposées à la surface du film mince 9, une opération de gravure chimique sélective en phase sèche est réalisée à travers le réseau d'interstices 11 crée. Cette opération est schématisée par les flèches F1 sur la figure 7. Elle permet, alors, de nanostructurer le film mince 9 et donc former le masque dur 8. En particulier, la gravure permet d'éliminer les parties du film mince 9 non recouvertes par les nanoparticules 10. Ces parties correspondent, plus particulièrement aux parties libres du film mince 9.

La gravure chimique en phase sèche est, en particulier, sélective vis-à-vis du matériau constituant le film mince 9. Ainsi, le composant chimique utilisé pour réaliser l'opération de gravure chimique permet de graver le film mince 9 plus rapidement que la couche mince en DLC 5. À titre d'exemple, une gravure chimique par plasma à l'aide d'un composé fluoré permet de graver un film mince 9 en carbure (hydrogéné) ou en oxyde de silicium plus rapidement que des nanoparticules 10, métalliques, en alliage métallique ou en polymère (la sélectivité de gravure du film mince 9 par rapport aux nanoparticules 10 est typiquement supérieure de 10 pour 1 également notée « 10 :1 ») et plus rapidement que la couche mince en DLC 5 (la sélectivité de gravure du film mince 9 par rapport au DLC est typiquement supérieur à 10:1).

À titre d'exemple, la nanostructuration du masque dur 8 peut être réalisée sur un équipement industriel du type NEXTRAL NE110 avec un débit de 2 Ncm³/min de SF₆ et de 20 Ncm³/min de CHF₃, une puissance plasma de 20 Watts, une polarisation de 300 V et une pression de 50 mT.

Une opération de gravure chimique sélective en phase sèche, schématisée par les flèches F2 sur la figure 8, est ensuite réalisée à travers le masque dur 8, afin de réaliser les ouvertures 6 dans la couche mince en DLC 5 et donc former le motif prédéterminé dans la couche mince nanostructurée 5 en DLC.

À ce stade, la gravure chimique est sélective dans la mesure où elle permet d'attaquer chimiquement le carbone quasi-diamant, sans attaquer le matériau formant le masque dur 8 et ni celui formant la couche mince barrière 4. En particulier, la gravure de la couche mince en DLC 5 est plus rapide que celle du masque dur 8. Ainsi, un plasma oxygène offre une sélectivité de 22 pour 1 (22 :1) entre le DLC et un masque dur 8 en carbure (hydrogéné) ou oxyde de silicium. Cela permet d'envisager l'emploi d'un masque dur très fin (par exemple d'une épaisseur de l'ordre de 10 nm d'épaisseur), ce qui présente l'avantage de réaliser très rapidement la nanostructuration du masque dur (c'est-à-dire d'obtenir un temps d'ouverture du masque dur 8 faible), ce qui est compatible avec la durée de vie du motif en exposition plasma (gravure physique du motif sous l'effet du bombardement d'ions). Le temps de gravure de la couche en DLC 5 est relativement supérieur à celui du temps d'ouverture du masque 8, ce qui permet d'éliminer physiquement les parties de la couche en DLC non recouvertes par le masque dur 8. La gravure de la couche mince en DLC 5 à travers le masque 8 peut également être réalisée sur un équipement industriel du type NEXTRAL NE110 avec un débit de 80 Ncm³/min d'oxygène, une puissance plasma de 10 Watts, une polarisation de 320 V et une pression de 20 mT.

De plus, la gravure est arrêtée par la couche mince barrière 4. Ainsi, les ouvertures 6 formées dans la couche mince en DLC 5 sont traversantes depuis la surface libre de la couche mince en DLC 5 jusqu'à l'interface 7 entre les couches minces 4 et 5. Le moule 1 est alors obtenu après le retrait du masque dur 8 (figure 9). Le retrait du masque dur 8 est, par exemple, réalisé par une opération de gravure analogue à celle utilisée pour graver le film mince 9 et ouvrir le masque dur 8.

II est à noter que les nanoparticules 10 étant de faible dimension et de masse peu élevée, elles sont faiblement liées à la surface du film mince 9. Elles sont progressivement et entièrement retirées de la surface du masque dur 8, sous l'effet du bombardement ionique inhérent aux différentes opérations de gravure chimique sélective en phase sèche. Il est donc important de maîtriser le temps de gravure pour ouvrir le masque dur 8 afin de ne pas éliminer les nanoparticules 10 lors de cette étape de gravure. Le temps de gravure du masque dur 8 est, en général, très court dans la mesure où le masque dur est très fin. Par conséquent, ceci explique pourquoi les nanoparticules 10 ne peuvent pas être utilisées directement comme masque pour nanostructurer la couche mince 5 en DLC. Elles seraient éliminées avant que la couche mince 5 en DLC ne soit nanostructurée sur toute son épaisseur. L'emploi des nanoparticules 10 permet également à la couche mince en DLC 5 de n'être quasiment pas affectée par l'étape de gravure du film mince 9 destiné à ouvrir le masque dur 8. Les nanoparticules 10 sont, ensuite, entièrement éliminées pendant l'étape de gravure de la couche mince en DLC 5 et éventuellement pendant le retrait du masque dur 8.

La formation du revêtement bicouche 3 sur le support métallique 2 peut éventuellement être localisée sur une partie seulement de la surface du support métallique 2. Dans ce cas, le procédé de réalisation du moule 1 peut comporter des étapes supplémentaires permettant de localiser le dépôt puis la nanostructuration du revêtement bicouche. Ainsi, l'étape de dépôt des couches 4 et 5 peut être précédée d'une étape de dépôt d'une couche en résine photosensible sur la surface du support métallique, suivie d'une opération de photolithographie. L'opération de photolithographie permet de créer des ouvertures dans la couche en résine destinées à délimiter les zones où seront déposées les couches minces 4 et 5. La couche en résine photosensible est retirée après la création du masque dur 8, par exemple par une opération dite de « lift-off ».

La réalisation d'un moule 1 selon le procédé décrit aux figures 2 à 9 et plus particulièrement la nanostructuration de la couche mince en DLC présentent l'avantage d'être faciles à mettre en oeuvre et à faible coût tout en garantissant l'obtention d'un moule de qualité. De plus, la couche mince en DLC nanostructurée peut, facilement être retirée lorsque cela s'avère nécessaire, en nettoyant le DLC par un plasma d'oxygène. Une nouvelle couche mince nanostructurée en DLC peut ensuite être redéposée en répétant les différentes étapes du procédé et représentées sur les figures 4 à 9.

Un tel moule peut, avantageusement, être utilisé pour réaliser des pièces nanostructurées en matériau polymère, utilisées dans de nombreux domaines : cellules solaires dans le domaine photovoltaïque, tableaux de bord non réfléchissant présentant des nanotextures dans le domaine automobile, hologrammes dans le domaine de l'étiquetage pour améliorer la traçabilité et éviter la contrefaçon, pièces présentant des surfaces autonettoyantes et super-hydrophobes... De plus, un tel moule peut également être utilisé, pour ses facultés à réduire le taux de défectivité sur les pièces polymères, les sources de contamination, les consommables chimiques de démoulage et de nettoyage du moule, dans des domaines tels que :
- l'emboutissage de concentrateurs optiques micro/nano-structurés pour les applications photovoltaïques
- l'injection de nanostructures pour les applications dans le domaine automobile (anti-reflet et auto-nettoyage)
- l'emboutissage de la prochaine génération de composants de sécurité
- la réalisation de surfaces biologiquement actives contre l'adhésion de bactéries/protéines ou pour la croissance de cellules
- la réalisation de membranes iso-poreuses.

## Revendications

1. Procédé de fabrication d'un moule pour pièces en matériau polymère comprenant les étapes suivantes :
- le dépôt successif, sur au moins une partie d'un support métallique (2), d'une couche mince barrière (4) et d'une couche mince en carbone quasi-diamant (5)
- et nanostructuration de la couche mince en carbone quasi-diamant (5) pour former au moins une surface nanostructurée destinée à venir en contact avec ledit matériau polymère,
la couche mince (5) en carbone quasi-diamant étant nanostructurée selon un motif prédéterminé présentant un rapport de forme supérieur à 1, en réalisant les étapes successives suivantes :
- formation, à la surface libre de ladite couche mince en carbone quasi-diamant (5), d'un masque dur (8) formé par une première opération de gravure chimique sélective en phase sèche réalisée à travers un réseau d'interstices (11) délimité par des nanoparticules (10) préalablement déposées sur la surface libre dudit masque dur (8)
- et formation du motif prédéterminé dans la couche mince en carbone quasi-diamant (5) par une seconde opération de gravure chimique sélective en phase sèche réalisée à travers le masque dur (8), ladite gravure s'arrêtant à l'interface (7) entre la couche mince en carbone quasi-diamant (5) et la couche mince barrière (4),
et en ce que le revêtement bicouche formé par la couche mince barrière (4) et la couche mince en carbone quasi-diamant (5) nanostructurée présente une épaisseur comprise entre environ 100 nm et environ 10 µm.

2. Procédé selon la revendication 1, ou le masque dur (8) est constitué d'un matériau choisi parmi l'oxyde de silicium, le carbure de silicium hydrogéné, le nitrure de silicium, l'aluminium, le cuivre, le chrome et un nitrure métallique.

3. Procédé selon l'une des revendications 1 et 2, ou le masque dur (8) a une épaisseur comprise entre environ 10nm et environ 50nm.

4. Procédé selon l'une quelconque des revendications 1 à 3, ou les nanoparticules (10) sont des nanoparticules d'un matériau choisi parmi l'argent, l'or, le palladium, le platine, le cuivre, le titane, le zirconium, l'oxyde de titane, l'oxyde de zirconium, le silicium, le carbure de silicium, l'oxyde de silicium et le nitrure de silicium et elles sont déposées par un procédé de pulvérisation magnétron.

5. Procédé selon l'une quelconque des revendications 1 à 4, ou les nanoparticules (10) sont des nanoparticules d'un oxyde de fer ou d'un métal choisi parmi l'argent, le platine et le cuivre et elles sont déposées par dépôt chimique en phase vapeur assisté par injection liquide.

6. Procédé selon l'une quelconque des revendications 1 à 5, ou les nanoparticules (10) sont des nanoparticules d'un matériau choisi parmi le carbure de silicium, l'oxyde de silicium, le nitrure de silicium, un matériau polymère, l'oxyde de titane et l'oxyde de zirconium et elles sont déposées par un procédé de type Langmuir-Blodgett.

7. Procédé selon l'une quelconque des revendications 1 à 6, ou le motif est constitué d'une pluralité d'ouvertures (6) traversant la couche mince en carbone quasi-diamant (5) depuis sa surface libre (5a) jusqu'à l'interface (7) entre ladite couche mince en carbone quasi-diamant (5) et la couche mince barrière (4).

8. Procédé selon l'une quelconque des revendications 1 à 7, ou la couche mince barrière (4) est en nitrure de chrome.

9. Procédé selon l'une quelconque des revendications 1 à 8, ou la couche mince barrière (4) est en carbure de silicium hydrogéné.

10. Procédé selon l'une des revendications 8 et 9, ou la couche mince barrière (4) a une épaisseur comprise entre 50nm et 500nm.

11. Procédé selon l'une quelconque des revendications 1 à 10, ou le support métallique (2) comporte un matériau métallique choisi parmi l'aluminium, l'acier et le laiton.

## Claims

1. Method for producing a mould for objects made of polymer material comprising the following steps :
- successive deposition of a barrier thin layer (4) and of a diamond-like carbon thin layer (5) on at least a part of a metal support (2),
- and nanopatterning of the diamond-like carbon thin layer (5) to form at least a nanopatterned surface designed to come into contact with said polymer material,
the diamond-like carbon thin layer (5) being nanopatterned with a predefined pattern presenting a form factor of more than 1 by performing the following successive steps:
- formation, on the free surface of said diamond-like carbon thin layer (5), of a hard mask (8) formed by a first dry-phase selective chemical etching operation through a void lattice (11) delineated by nanoparticles (10) deposited beforehand on the free surface of said hard mask (8),
- and formation of the predefined pattern in the diamond-like carbon thin layer (5) by a second dry-phase selective chemical etching operation through the hard mask (8), said etching stopping at the interface (7) between the diamond-like carbon thin layer (5) and the barrier thin layer (4),
and that the bilayer coating formed by the barrier thin layer (4) and the nanopatterned diamond-like carbon thin layer (5) presents a thickness comprised between about 100 nm and about 10 µm.

2. Method according to claim 1, wherein the hard mask (8) is formed by a material chosen from silicon oxide, hydrogenated silicon carbide, silicon nitride, aluminium, copper, chromium and a metal nitride.

3. Method according to one of claims 1 and 2, wherein the hard mask (8) has a thickness comprised between about 10 nm and about 50 nm.

4. Method according to any one of claims 1 to 3, wherein the nanoparticles (10) are nanoparticles of a material chosen from silver, gold, palladium, platinum, copper, titanium, zirconium, titanium oxide, zirconium oxide, silicon, silicon carbide, silicon oxide and silicon nitride and in that they are deposited by a magnetron sputtering method.

5. Method according to any one of claims 1 to 4, wherein the nanoparticles (10) are nanoparticles of an iron oxide or of a metal chosen from silver, platinum and copper and in that they are deposited by chemical vapor deposition assisted by liquid injection.

6. Method according to any one of claims 1 to 5, wherein the nanoparticles (10) are nanoparticles of a material chosen from silicon carbide, silicon oxide, silicon nitride, a polymer material, titanium oxide and zirconium oxide and in that they are deposited by a Langmuir-Blodgett type method.

7. Method according to any one of claims 1 to 6, wherein the pattern is formed by a plurality of openings (6) passing through the diamond-like carbon thin layer (5) from its free surface (5a) to the interface (7) between said diamond-like carbon thin layer (5) and the barrier thin layer (4).

8. Method according to any one of claims 1 to 7, wherein the barrier thin layer (4) is made from chromium nitride.

9. Method according to any one of claims 1 to 8, wherein the barrier thin layer (4) is made from hydrogenated silicon carbide.

10. Method according to one of claims 8 and 9, wherein the barrier thin layer (4) has a thickness comprised between 50 nm and 500 nm.

11. Method according to any one of claims 1 to 10, wherein the metal support (2) comprises a metal material chosen from aluminium, steel and brass.

## Patentansprüche

1. Verfahren zur Herstellung einer Form für Teile aus Polymerwerkstoff, die folgenden Schritte umfassend:
- Aufeinanderfolgendes Aufbringen einer Dünnschicht mit Sperrwirkung (4) und einer Dünnschicht aus diamantartigem Kohlenstoff (5) auf mindestens einen Abschnitt eines Metallträgers (2)
- und Nanostrukturieren der Dünnschicht aus diamantartigem Kohlenstoff (5), um mindestens eine nanostrukturierte Oberfläche zu bilden, die dazu bestimmt ist, mit dem Polymerwerkstoff in Kontakt zu kommen,
- wobei die Dünnschicht (5) aus diamantartigem Kohlenstoff gemäß einem zuvor festgelegten Muster nanostrukturiert wird, das ein Seitenverhältnis von mehr als 1 aufweist, indem die folgenden Schritte nacheinander durchgeführt werden:
- Bilden einer harten Formmaske (8) auf der freiliegenden Oberfläche der Dünnschicht aus diamantartigem Kohlenstoff (5), wobei die Marke durch einen ersten selektiven chemischen Trockenätzvorgang gebildet wird, welcher durch ein Netzwerk von Zwischenräumen (11) erfolgt, das von Nanopartikeln (10) abgegrenzt wird, die zuvor auf die freiliegende Oberfläche der harten Formmaske (8) aufgebracht wurden
- und Bilden des zuvor festgelegten Musters in der Dünnschicht aus diamantartigem Kohlenstoff (5) durch einen zweiten selektiven chemischen Trockenätzvorgang, welcher durch die harte Formmaske (8) erfolgt, wobei der Ätzvorgang nur bis zur Grenzschicht (7) zwischen der Dünnschicht aus diamantartigem Kohlenstoff (5) und der Dünnschicht mit Sperrwirkung (4) voranschreitet,
und **dadurch**, dass die zweilagige Beschichtung, die aus der Dünnschicht mit Sperrwirkung (4) und der nanostrukturierten Dünnschicht aus diamantartigem Kohlenstoff (5) gebildet ist, eine Dicke im Bereich von ungefähr 100 nm bis ungefähr 10 µm aufweist.

2. Verfahren nach Anspruch 1, wobei die harte Formmaske (8) aus einem Werkstoff besteht, der aus Siliciumoxid, wasserstoffhaltigem Siliciumcarbid, Siliciumnitrid, Aluminium, Kupfer, Chrom und einem Metallnitrid ausgewählt ist.

3. Verfahren nach einem der Ansprüche 1 und 2, wobei die harte Formmaske (8) eine Dicke im Bereich von ungefähr 10 nm bis ungefähr 50 nm hat.

4. Verfahren nach einem beliebigen der Ansprüche 1 bis 3, wobei es sich bei den Nanopartikeln (10) um Nanopartikel aus einem Werkstoff handelt, der aus Silber, Gold, Palladium, Platin, Kupfer, Titan, Zirkonium, Titanoxid, Zirkoniumoxid, Silicium, Siliciumcarbid, Siliciumoxid und Siliciumnitrid ausgewählt ist, und sie mittels eines Magnetron-Zerstäubungsverfahrens aufgebracht werden.

5. Verfahren nach einem beliebigen der Ansprüche 1 bis 4, wobei es sich bei den Nanopartikeln (10) um Nanopartikel aus einem Eisenoxid oder einem Metall handelt, das aus Silber, Platin und Kupfer ausgewählt ist, und sie mittels chemischer Gasphasenabscheidung mit unterstützender Flüssigeinspritzung aufgebracht werden.

6. Verfahren nach einem beliebigen der Ansprüche 1 bis 5, wobei es sich bei den Nanopartikeln (10) um Nanopartikel aus einem Werkstoff handelt, der aus Siliciumcarbid, Siliciumoxid und Siliciumnitrid, einem Polymerwerkstoff, Titanoxid und Zirkoniumoxid ausgewählt ist, und sie mittels eines Verfahrens des Typs Langmuir-Blodgett aufgebracht werden.

7. Verfahren nach einem beliebigen der Ansprüche 1 bis 6, wobei das Muster aus mehreren Öffnungen (6) besteht, welche die Dünnschicht aus diamantartigem Kohlenstoff (5) von ihrer freiliegenden Oberfläche (5a) bis zur Grenzschicht (7) zwischen der Dünnschicht aus diamantartigem Kohlenstoff (5) und der Dünnschicht mit Sperrwirkung (4) durchziehen.

8. Verfahren nach einem beliebigen der Ansprüche 1 bis 7, wobei die Dünnschicht mit Sperrwirkung (4) aus Chromnitrid ist.

9. Verfahren nach einem beliebigen der Ansprüche 1 bis 8, wobei die Dünnschicht mit Sperrwirkung (4) aus wasserstoffhaltigem Siliciumcarbid ist.

10. Verfahren nach einem der Ansprüche 8 und 9, wobei die Dünnschicht mit Sperrwirkung (4) eine Dicke im Bereich von 50 nm bis 500 nm hat.

11. Verfahren nach einem beliebigen der Ansprüche 1 bis 10, wobei der Metallträger (2) einen metallischen Werkstoff aufweist, der aus Aluminium, Stahl und Messing ausgewählt ist.
